Europäisches Patentamt

European Patent Office

Office européen des brevets

(19)

(11) **EP 1 342 094 B1**

(12) **FASCICULE DE BREVET EUROPEEN**

(45) Date de publication et mention
de la délivrance du brevet:
**09.06.2004   Bulletin 2004/24**

(51) Int Cl.⁷: **G01R 27/28**, G01R 31/00,
G01R 29/08

(21) Numéro de dépôt: **01999827.7**

(22) Date de dépôt: **28.11.2001**

(86) Numéro de dépôt international:
**PCT/FR2001/003767**

(87) Numéro de publication internationale:
**WO 2002/046780 (13.06.2002 Gazette 2002/24)**

(54) **DISPOSITIF DE CARACTERISATION ELECTROMAGNETIQUE D'UNE STRUCTURE SOUS TEST**

EINRICHTUNG ZUM ELEKTROMAGNETISCHEN CHARAKTERISIEREN EINER ZU TESTENDEN
STRUKTUR

DEVICE FOR ELECTROMAGNETIC CHARACTERISATION OF A TESTED STRUCTURE

(84) Etats contractants désignés:
**AT BE CH CY DE DK ES FI FR GB GR IE IT LI LU
MC NL PT SE TR**

(30) Priorité:  **04.12.2000  FR 0015700**

(43) Date de publication de la demande:
**10.09.2003   Bulletin 2003/37**

(73) Titulaire: **CENTRE NATIONAL DE
LA RECHERCHE SCIENTIFIQUE (CNRS)
75016 Paris (FR)**

(72) Inventeurs:
 • **JECKO, Bernard, Jean, Yves
F-87570 Rilhac Rançon (FR)**
 • **MARTINOD, Edson, Antoine, André
F-19410 Vigeois (FR)**
 • **LALANDE-GUIONIE, Michèle, Marie
F-19100 Brive (FR)**

 • **REINEIX, Alain, Jean, Louis
F-87570 Rilhac Rançon (FR)**

(74) Mandataire: **Fréchède, Michel et al
Cabinet Lavoix
2 Place d'Estienne d'Orves
75441 Paris Cedex 09 (FR)**

(56) Documents cités:
**EP-A- 0 736 776          EP-A- 0 810 445
EP-A- 0 822 671          FR-A- 2 751 415**

 • **SCHUTTE A ET AL: "COMPARISON OF TIME
DOMAIN AND FREQUENCY DOMAIN
ELECTROMAGNETIC SUSCEPTIBILITY
TESTING" RECORD OF THE INTERNATIONAL
SYMPOSIUM ON ELECTROMAGNETIC
COMPATIBILITY(EMC). CHICAGO, AUG. 22 - 26,
1994, NEW YORK, IEEE, US, 22 août 1994
(1994-08-22), pages 64-67, XP000503290 ISBN:
0-7803-1399-2**

EP 1 342 094 B1

# EP 1 342 094 B1

**Description**

La présente invention concerne un dispositif de caractérisation électromagnétique d'une structure sous test, et un procédé correspondant.

Plus précisément, l'invention concerne un dispositif de caractérisation électromagnétique d'une structure sous test terminée par des connecteurs reliés à des lignes de transmission d'impédance quelconque, par l'évaluation, sur une bande de fréquences prédéterminée, de paramètres de répartition de cette structure et de paramètres caractéristiques des rayonnements parasites de cette structure. Ce dispositif comporte un générateur de signal électrique, des moyens de transmission de ce signal électrique à la structure sous test, des moyens d'analyse du signal émis par le générateur, ainsi que des signaux réfléchis par la structure et des signaux transmis par la structure, les moyens d'analyse comportant des moyens de calcul des paramètres de répartition de la structure sous test et des paramètres caractéristiques des rayonnements parasites.

FR-A-2 751 415 expose un banc de mesure d'impédance de transfert pour connecteurs et câbles électriques.

De façon classique, un tel dispositif, utilisé par exemple pour la caractérisation électromagnétique d'un connecteur électrique, comporte généralement un analyseur de réseau connecté aux deux bornes du connecteur électrique.

L'analyseur de réseau comprend un générateur de signal sinusoïdal dont la fréquence peut être réglée à l'intérieur de la bande de fréquences prédéterminée. Il transmet ce signal à l'une quelconque des deux bornes du connecteur et reçoit en retour un signal réfléchi par cette borne et un signal transmis par l'autre borne.

Cependant, l'analyseur de réseau reçoit également des signaux parasites à la même fréquence, provenant notamment d'ondes électromagnétiques issues d'un rayonnement du dispositif de caractérisation et de la structure sous test et rétrodiffusées par les parois d'un local dans lequel est placé le dispositif de caractérisation électromagnétique.

La fréquence des signaux parasites étant la même que celle des signaux à analyser, l'analyseur de réseau ne peut pas différencier ces signaux. Pour obtenir des mesures précises, il est donc nécessaire de placer le dispositif de caractérisation électromagnétique et la structure sous test dans une chambre anéchoïde, laquelle absorbe les ondes électromagnétiques rayonnées.

De plus, pour caractériser la structure sous test sur toute la bande de fréquences prédéterminée, le générateur de signal de l'analyseur de réseau doit fournir une multiplicité de signaux sinusoïdaux successifs balayant ladite bande de fréquences.

L'invention vise à remédier à ces inconvénients en créant un dispositif capable d'effectuer précisément les mesures de caractérisation électromagnétique, tout en étant simple et peut coûteux.

L'invention a donc pour objet un dispositif de caractérisation électromagnétique d'une structure sous test terminée par des connecteurs reliés à des lignes de transmission d'impédance quelconque, par l'évaluation, sur une bande de fréquences prédéterminée, de paramètres de répartition de cette structure et de paramètres caractéristiques des rayonnements parasites de cette structure, comportant un générateur de signal électrique, des moyens de transmission de ce signal électrique à la structure sous test, des moyens d'analyse du signal émis par le générateur ainsi que des signaux réfléchis par la structure et des signaux transmis par la structure, les moyens d'analyse comportant des moyens de calcul des paramètres de répartition et des paramètres caractéristiques des rayonnements de la structure sous test, caractérisé en ce que le générateur de signal électrique est un générateur d'un signal impulsionnel, dont le spectre est au moins aussi large que ladite bande de fréquences prédéterminée, le générateur étant adapté pour émettre au moins une fois ce signal impulsionnel, et en ce que les moyens d'analyse comportent des moyens de filtrage temporel des signaux qu'ils reçoivent, pour l'élimination de signaux parasites.

Ainsi, le dispositif de caractérisation électromagnétique selon l'invention permet de caractériser la structure sous test, sur toute la bande de fréquences prédéterminée, par la génération d'un seul signal impulsionnel dont le spectre couvre cette bande de fréquences, ce signal impulsionnel pouvant être émis une ou plusieurs fois par le générateur.

De plus, les signaux reçus en retour par les moyens d'analyse du dispositif de caractérisation électromagnétique sont également des signaux impulsionnels, qu'il s'agisse des signaux réfléchis et transmis par la structure sous test ou des signaux parasites.

Ainsi, les moyens d'analyse comportant en outre des moyens de filtrage temporel de ces signaux, il est aisé pour eux d'éliminer les signaux parasites, sans nécessiter le placement du dispositif en chambre anéchoïde.

Le dispositif de caractérisation électromagnétique selon l'invention peut en outre comporter une ou plusieurs des caractéristiques suivantes :

- la structure sous test étant terminée par des connecteurs multifilaires, le dispositif comporte en outre des moyens d'adaptation d'impédance et de mode de propagation disposés entre ces connecteurs multifilaires et le reste du dispositif ;

- la structure sous test étant terminée par des connecteurs reliés chacun à au moins une ligne bifilaire, les moyens d'adaptation comportent une pluralité d'adaptateurs de chaque ligne bifilaire, disposés de part et d'autre de la structure sous test, chacun comprenant un circuit de fractionnement de tension et une borne de connexion bifilaire formée par les deux conducteurs centraux de deux câbles coaxiaux dont les conducteurs extérieurs sont court-circuités ;
- le dispositif comporte en outre des moyens de transmission du signal impulsionnel seul, aux moyens d'analyse pour la fourniture d'un signal de référence à ceux-ci ;
- la largeur de la bande de fréquences prédéterminée est supérieure ou égale à 1 GHz ;
- le signal impulsionnel est un signal impulsionnel de forme générale gaussienne ;
- les moyens d'analyse comportent une première voie de traitement du signal émis par le générateur et du signal réfléchi par la structure sous test, comprenant au moins une voie de réception et une seconde voie de traitement du signal transmis par la structure sous test comprenant au moins une voie de réception ;
- les moyens de filtrage temporel comportent des premiers moyens de sélection entre des instants prédéterminés d'une partie des signaux reçus par la première voie de traitement, cette partie contenant uniquement le signal réfléchi par la structure sous test, et des seconds moyens de sélection entre des instants prédéterminés d'une partie des signaux reçus par la seconde voie de traitement, cette partie contenant uniquement le signal transmis par la structure sous test ;
- des moyens de prolongement par continuité de ladite partie contenant uniquement le signal transmis par la structure sous test, pour la reconstitution de ce signal transmis, sont associés auxdits seconds moyens de sélection ;
- la structure sous test est un connecteur de liaisons multifilaires
- les moyens de calcul comportent des moyens de calcul du taux de puissance rayonnée par la structure sous test ; et
- la structure sous test étant un connecteur de liaisons multifilaires, les moyens de calcul comportent des moyens de calcul du champ rayonné par ce connecteur, lorsque celui-ci est utilisé dans la mise en oeuvre d'une liaison entre un émetteur et un récepteur de signaux électriques.

L'invention a également pour objet un procédé de caractérisation électromagnétique d'une structure sous test terminée par des connecteurs reliés à des lignes de transmission d'impédance quelconque, par l'évaluation, sur une bande de fréquences prédéterminée, de paramètres de répartition de cette structure et de paramètres caractéristiques des rayonnements parasites de cette structure, le procédé comportant les étapes suivantes :

l'émission, au moins une fois, par un générateur d'un signal électrique vers la structure sous test ;
- la réception du signal émis par le générateur ainsi que des signaux réfléchis par la structure et des signaux transmis par la structure, par des moyens d'analyse; et
- le calcul par les moyens d'analyse des paramètres de répartition de la structure sous test et des paramètres caractéristiques des rayonnements parasites de cette structure,

caractérisé en ce que le signal électrique est un signal impulsionnel de largeur spectrale supérieure à ladite bande de fréquences prédéterminée, et en ce que le procédé comporte en outre une étape de filtrage temporel des signaux reçus par les moyens d'analyse, pour l'élimination de signaux parasites.

L'invention sera mieux comprise à la lecture de la description qui va suivre, donnée uniquement à titre d'exemple et faite en se référant aux dessins annexés, sur lesquels :

- la Fig.1 est une vue schématique de la structure générale d'un dispositif selon un premier mode de réalisation de l'invention ;
- la Fig.2 représente l'allure temporelle et le spectre d'une impulsion fournie par un générateur du dispositif de la figure 1 ;
- la Fig.3 représente schématiquement la structure de moyens d'analyse du dispositif de la figure 1 ;
- la Fig.4 est une vue schématique de la structure générale d'un dispositif selon un second mode de réalisation de l'invention ;
- la Fig.5 est une vue schématique de moyens d'adaptation du dispositif de la figure 4 ;
- la Fig.6 est une vue schématique de la structure générale d'un dispositif de fourniture d'un signal de référence aux moyens d'analyse de la figure 3 ;
- les Figs.7A à 7D représentent l'allure d'un signal reçu et traité par une première voie de traitement des moyens d'analyse de la figure 3 ;
- les Figs.8A à 8D représentent l'allure d'un signal reçu et traité par une seconde voie de traitement des moyens d'analyse de la figure 3 ; et
- la Fig.9 est une vue schématique d'une liaison entre un émetteur et un récepteur, utilisant des connecteurs testés par le dispositif de la figure 1.

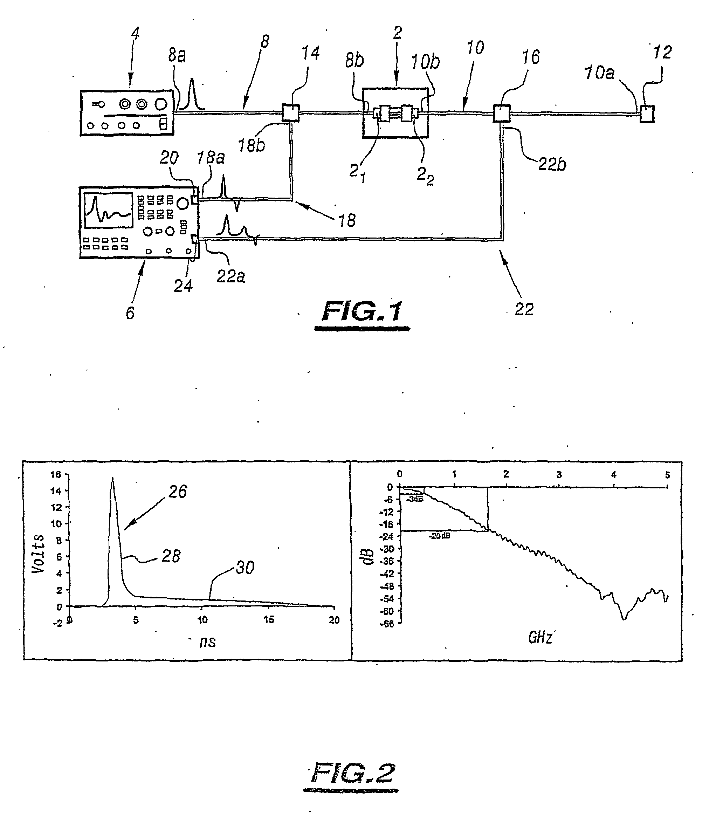

Le dispositif de caractérisation électromagnétique représenté à la figure 1 comporte une structure sous test 2 constituée d'un connecteur de câbles coaxiaux d'impédance 50 Ohms, un générateur d'impulsions 4 et des moyens d'analyse 6.

Un premier câble coaxial de transmission 8 est disposé entre le générateur d'impulsions 4 et le connecteur 2. Il comporte une extrémité 8a connectée en sortie du générateur d'impulsions 4 et une autre extrémité 8b connectée à une première borne $2_1$ du connecteur 2.

Un deuxième câble coaxial de transmission 10 est disposé entre le connecteur 2 et une charge 12. Une extrémité 10a de ce deuxième câble 10 est connectée à la charge 12, tandis que l'autre extrémité 10b du deuxième câble 10 est connectée à une seconde borne $2_2$ du connecteur 2.

Une sonde 14 est disposée sur le premier câble de transmission 8, pour recueillir un signal émis par le générateur d'impulsions 4 et un signal réfléchi par le connecteur 2.

Une sonde 16 est disposée sur le deuxième câble de transmission 10, pour recueillir un signal transmis par le connecteur 2.

Un troisième câble de transmission 1.8 est disposé entre les moyens d'analyse 6 et la sonde 14. Une première extrémité 18a de ce troisième câble 18 est connectée à une première voie de réception 20 des moyens d'analyse 6, tandis que son autre extrémité 18b est connectée à la sonde 14.

Un quatrième câble de transmission 22 est disposé entre les moyens d'analyse 6 et la sonde 16. Une première extrémité 22a de ce quatrième câble de transmission 22 est connectée à une seconde voie de réception 24 des moyens d'analyse 6, tandis que son autre extrémité 22b est connectée à la sonde 16.

Le dispositif tel que décrit précédemment est monté en sens direct.

Il permet à la première voie de réception 20 de recevoir le signal émis par le générateur d'impulsions 4 et le signal réfléchi par le connecteur 2 au niveau de sa première borne $2_1$. Il permet en outre à la seconde voie de réception 24 de recevoir le signal transmis par le connecteur 2 au niveau de sa seconde borne $2_2$.

Il est cependant possible d'intervertir le générateur d'impulsions 4 et la charge 12, de sorte que la charge 12 soit connectée à l'extrémité 8a du premier câble de transmission 8 et que le générateur d'impulsions 4 soit connecté à l'extrémité 10a du deuxième câble de transmission 10. Dans ce cas, le dispositif est monté en sens inverse.

Le dispositif monté en sens inverse permet à la seconde voie de réception 24 de recevoir le signal émis par le générateur d'impulsions 4 et le signal réfléchi par le connecteur 2 au niveau de sa seconde borne $2_2$. Il permet en outre à la première voie de réception 20 de recevoir le signal transmis par le connecteur 2 au niveau de sa première borne $2_1$.

Le générateur d'impulsions 4 utilisé est par exemple le générateur connu sous la référence PSPL2600C et commercialisé par la société PICOSECOND PULSE LABS. Ce générateur présente une impédance de sortie de 50 Ohms.

Comme cela est représenté à la figure 2, ce générateur d'impulsions 4 fournit un signal impulsionnel 26 présentant une première partie 28 de forme gaussienne de courte durée, suivie d'une seconde partie 30 linéaire de faible amplitude, mais tendant plus lentement vers 0.

On notera que la bande passante à -20dB de ce signal impulsionnel 26 est supérieure à 1,5 GHz.

Les sondes 14 et 16 utilisées sont de préférence du type PSPL 5520C commercialisées par la société PICOSECOND PULSE LABS. Elles présentent une impédance de 50 Ohms et une bande passante supérieure à 3 GHz.

Les câbles de transmission 8,10,18 et 22 utilisés sont de type classique. Ils présentent une impédance de 50 Ohms et permettent la propagation du signal impulsionnel délivré par le générateur 4 ainsi que du signal impulsionnel réfléchi et du signal impulsionnel transmis par le connecteur 2, sans déformer leur forme temporelle et, par conséquent, sans altérer leur contenu spectral.

Les moyens d'analyse 6 comprennent par exemple un oscilloscope à échantillonnage direct, tel que l'oscilloscope TDS 694C commercialisé par là société TEKTRONIX. Cet oscilloscope permet l'acquisition d'un signal en une seule fois, pour un nombre d'échantillons et une résolution verticale limités.

Mais, les moyens d'analyse 6 comprennent de préférence un oscilloscope à échantillonnage séquentiel, tel que l'oscilloscope TDS 820 commercialisé par la société TEKTRONIX.

L'utilisation d'un tel oscilloscope nécessite que le générateur d'impulsions 4 émette une pluralité de signaux impulsionnels identiques à intervalles réguliers.

L'oscilloscope numérique 6 prélève alors périodiquement des échantillons, selon une période légèrement supérieure à la période d'émission des signaux impulsionnels. Cette période de prélèvement d'échantillons est réglée en fonction du nombre total d'échantillons à prélever et le nombre de signaux impulsionnels à émettre par le générateur est égal au nombre d'échantillons à prélever au cours d'une mesure.

En contrepartie, cet oscilloscope permet l'acquisition d'un signal, avec un nombre d'échantillons et une résolution verticale nettement supérieurs à ceux permis par un oscilloscope à échantillonnage direct.

Les moyens d'analyse 6 comprennent également, par exemple, un micro-ordinateur relié à l'oscilloscope, pour effectuer une partie des traitements et calculs permettant la détermination des paramètres de répartition du connecteur 2 et des paramètres caractéristiques des rayonnements parasites de ce connecteur, comme, notamment la puissance et le champ rayonnés par le connecteur 2.

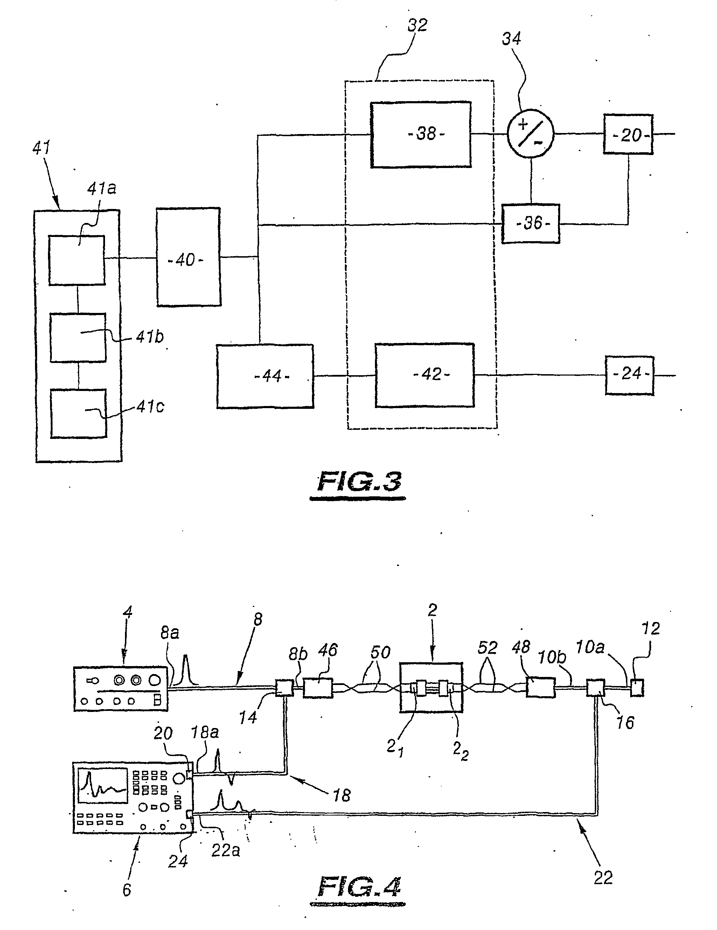

En référence à la figure 3, les première et seconde voies de réception 20 et 24 des moyens d'analyse 6 du dispositif de caractéristiques électromagnétiques monté en sens direct reçoivent des signaux électriques captés par les sondes 14 et 16. Elles fournissent en sortie, des signaux numériques, obtenus par échantillonnage de ces signaux électriques.

Le signal fourni par la première voie de réception 20, qui contient le signal 26 émis par le générateur d'impulsions 4, le signal réfléchi par le connecteur 2 et des signaux parasites, est transmis à une entrée d'un soustracteur 34. Une seconde entrée du soustracteur 34 est connectée à une mémoire 36 de type RAM, connectée en outre à la première entrée 20. Dans cette mémoire 26 sont stockées des données relatives au signal 26 émis par le générateur d'impulsions 4.

Ces données sont enregistrées lors d'une étape de fourniture d'un signal de référence, qui sera décrite ultérieurement.

Le soustracteur 34 fournit en sortie un signal à un filtre 38 des moyens 32 de filtrage temporel. Ce dernier effectue une sélection temporelle d'une partie dudit signal, entre deux instants prédéterminés TO et T1.

La première voie de réception 20, le soustracteur 34 et le filtre 38 constituent une première voie de traitement des moyens d'analyse 6.

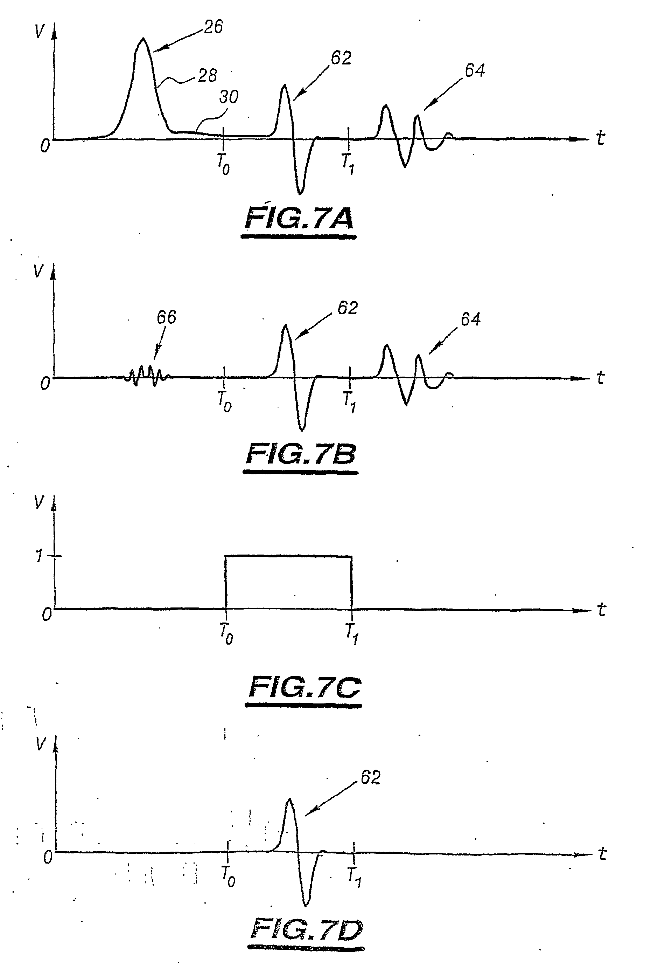

Le traitement du signal en provenance de la première voie de réception 20, par cette première voie de traitement sera décrit en référence aux figures 7A à 7D. Il permet d'obtenir en fin de traitement, uniquement le signal réfléchi par le connecteur 2.

Le signal fourni en sortie du filtre 38 est alors transmis par les moyens de filtrage temporel 32 à un circuit 40 de calcul de spectre.

Le circuit 40 de calcul de spectre est en outre connecté à la mémoire 36, ce qui lui permet ainsi de recevoir également en entrée le signal 26 émis par le générateur d'impulsions 4.

Le circuit 40 est adapté pour calculer le spectre d'un signal fourni en entrée.

Dans les moyens de filtrage 32, le signal échantillonné fourni par la seconde entrée 24 des moyens d'analyse 6, qui comprend le signal transmis par le connecteur 2 et des signaux parasites, est transmis à un filtre 42 des moyens 32 de filtrage temporel, effectuant une sélection temporelle d'une partie de ce signal entre deux instants prédéterminés T2 et T3.

Le signal fournit en sortie du filtre 42 est transmis par les moyens 32 de filtrage temporel à des moyens 44 de prolongement par continuité de ce signal.

La seconde voie de réception 24, le filtre 42 et les moyens 44 de prolongement par continuité constituent une seconde voie de traitement des moyens d'analyse 6.

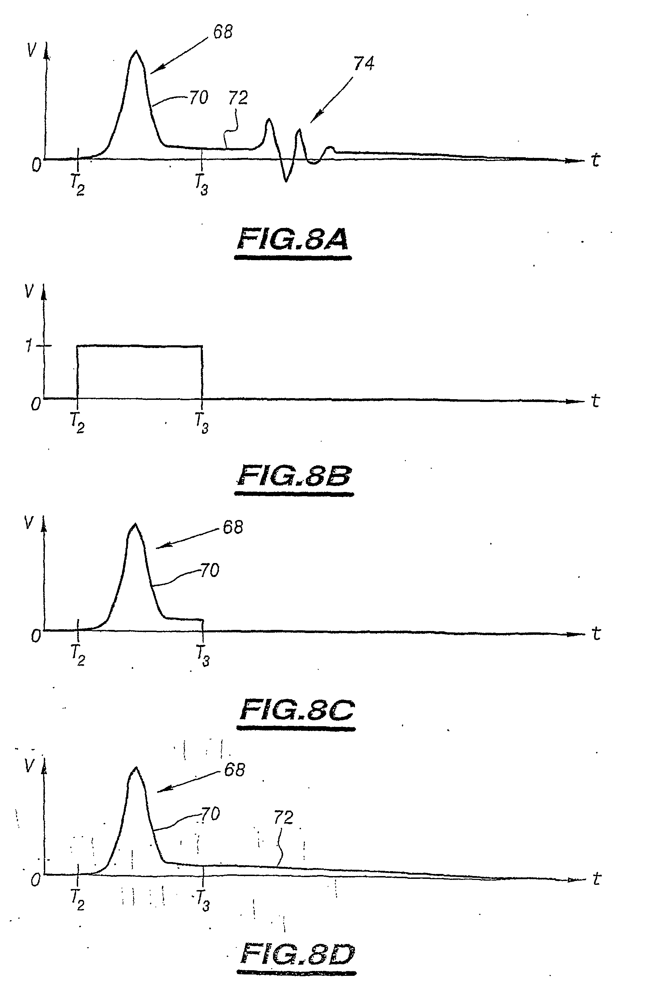

Le traitement du signal en provenance de la seconde voie de réception 24, par cette seconde voie de traitement, sera décrit en référence aux figures 8A à 8D. Il permet d'obtenir, en fin de traitement, uniquement le signal transmis par le connecteur 2.

Le signal fourni en sortie des moyens 44 de prolongement par continuité est transmis au circuit 40 de calcul de spectre.

Le circuit 40 de calcul de spectre est connecté en sortie à un calculateur 41 auquel il fournit les coefficients spectraux du signal 26 émis par le générateur d'impulsions 4, du signal réfléchi par le connecteur 2 et du signal transmis par ce même connecteur 2, après avoir effectué le calcul de leur spectre.

Le calculateur 41 est adapté pour fournir les paramètres de répartition du connecteur 2 ainsi que les paramètres caractéristiques des rayonnements parasites de ce connecteur, à partir de ces coefficients spectraux.

Il comporte des moyens 41 a de calcul des paramètres de répartition du connecteur 2, des moyens 41b de calcul de la puissance rayonnée par le connecteur 2 et des moyens 41 c de calcul du champ rayonné par le connecteur 2. Son fonctionnement sera détaillé par la suite.

Les moyens d'analyse 6 représentés à la figure 3 ont été décrits conformément au dispositif représenté à la figure 1, c'est à dire en sens direct.

Lorsque le dispositif de caractérisation électromagnétique est monté en sens inverse, il convient de relier la première voie de réception 20 au filtre 42 et la seconde voie de réception 24 au soustracteur 34 et à la mémoire RAM 36.

Ainsi, les moyens d'analyse 6 sont adaptés pour que la première voie de traitement-soit constituée par la seconde voie de réception 24, le soustracteur 36 et le filtre 38, et pour que la seconde voie de traitement soit constituée par la première voie de réception 20, le filtre 42 et les moyens 44 de prolongement par continuité. Cette adaptation est automatique et effectuée par des moyens logiciels.

Le dispositif de caractérisation électromagnétique représenté à la figure 4 concerne un autre mode de réalisation possible de l'invention. il comporte, cette fois-ci, une structure sous test 2 constituée d'un connecteur de liaisons multifilaires, dont l'impédance est différente de 50 Ohms. On se limitera, dans la description de la figure 4, au cas d'un connecteur de liaisons bifilaires d'impédance 100 Ohms.

Dans ce mode de réalisation, dans lequel le dispositif est monté en sens direct, le générateur d'impulsions 4, les moyens d'analyse 6, la charge 12, les sondes 14 et 16, les troisième et quatrième câbles de transmission 18 et 22, sont identiques à ceux décrits en référence à la figure 1 et sont disposés de la même manière.

Par contre, le connecteur 2 étant un connecteur de liaisons bifilaires, les premier et deuxième câbles de transmission 8,10 ne peuvent pas être directement reliés aux bornes $2_1$ et $2_2$ de ce connecteur.

Ainsi, le premier câble de transmission 8 est connecté d'une part, par son extrémité 8a au générateur d'impulsions 4, et d'autre part par son extrémité 8b à un premier adaptateur 46. Le deuxième câble de transmission 10 est, quant à lui, connecté d'une part, à la charge 12 par son extrémité 10a et d'autre part à un second adaptateur 48 par son extrémité 10b.

Le premier adaptateur 46 est en outre connecté à la borne $2_1$ du connecteur bifilaire 2 au moyen d'une liaison binaire 50 et le second adaptateur 48 est en outre connecté à la borne $2_2$ du connecteur bifilaire 2 au moyen d'une liaison bifilaire 52.

Les premier et second adaptateurs 46 et 48 doivent réaliser une adaptation entre un mode de propagation coaxial d'un signal dans les câbles 8 et 10 et un mode de propagation différentiel dans les liaisons bifilaires 50 et 52.

De plus, puisque le connecteur 2 présente une impédance de 100 Ohms, alors que le générateur 4, les moyens d'analyse 6, les câbles 8,10,18 et 22, les sondes 14 et 16 ont chacun une impédance de 50 Ohms, les adaptateurs 46 et 48 doivent en outre réaliser une adaptation d'impédance de 50 à 100 Ohms.

Enfin, les adaptateurs 46 et 48 doivent être bidirectionnels.

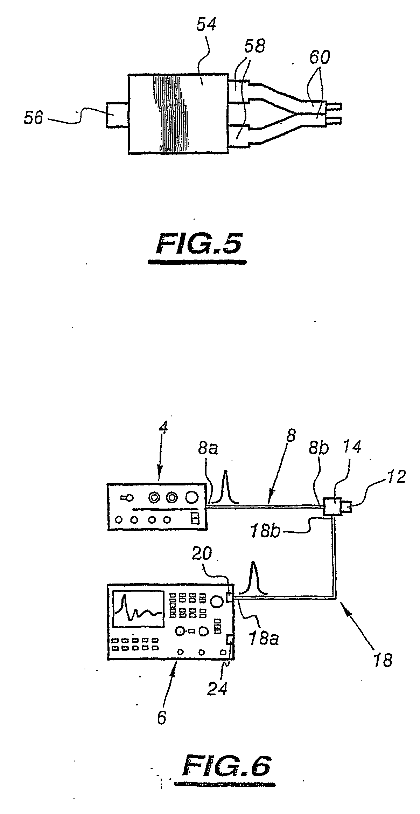

Ces deux adaptateurs étant identiques, l'un d'entre eux, par exemple l'adaptateur 46, est représenté à la figure 5. Il comporte, par exemple, un circuit 54 de fractionnement de tension.

Ce circuit 54 comporte une borne d'entrée coaxiale 56, pour recevoir l'extrémité 8b du premier câble de transmission 8, et deux bornes de sortie coaxiales 58, auxquelles sont connectés deux câbles coaxiaux 60 semi-rigides.

Les conducteurs extérieurs des deux câbles coaxiaux 60 sont soudés en leur extrémité opposée aux bornes de sortie 58 pour les court-circuiter et réaliser ainsi l'adaptation d'impédance. L'âme centrale de chacun de ces deux câbles coaxiaux 60 est adaptée pour recevoir un des deux fils de la liaison bifilaire 50 ou 52.

Le dispositif décrit en référence aux figures 4 et 5 peut être adapté simplement pour permettre la caractérisation d'une structure terminée par des connecteurs de liaisons multifilaires à 2n fils, n étant un nombre entier quelconque.

En effet, dans ce cas, une liaison multifilaire peut être considérée comme n liaisons bifilaires. Chacune de ces n liaisons bifilaires est alors connectée à un adaptateur tel que celui décrit en référence à la figure 5.

Le dispositif de caractérisation électromagnétique comporte alors n adaptateurs tels que l'adaptateur 46, n adaptateurs tels que l'adaptateur 48, n câbles tels que le câble 8, n câbles tels que le câble 10, n câbles tels que le câble 18, n câbles tels que le câble 22, n sondes telles que la sonde 14, n sondes telles que la sonde 16 et n charges telles que la charge 12.

Il convient alors de fournir des moyens d'analyse 6 comportant n voies de réception telles que la voie de réception 20 et n voies dé réception telles que la voie de réception 24.

Le dispositif de fourniture d'un signal de référence aux moyens d'analyse 6 représenté à la figure 6 comporte le générateur d'impulsions 4 connecté à l'extrémité 8a du premier câble de transmission 8. L'extrémité 8b du premier câble de transmission est connectée à la charge 12.

La sonde 14 est disposée sur le premier câble de transmission 8 au niveau de son extrémité 8b et est connectée à l'extrémité 18b du troisième câble de transmission 18.

L'extrémité 18a de ce troisième câble de transmission 18 est connectée à la première voie de réception 20 des moyens d'analyse 6.

Le fonctionnement des moyens d'analyse 6 du dispositif représenté à la figure 1, du dispositif représenté à la figure 4 ou du dispositif représenté à la figure 6, va maintenant être décrit.

Les moyens d'analyse 6 effectuent le calcul de quatre paramètres $S_{11}$, $S_{21}$, $S_{12}$ et $S_{22}$ de répartition de la structure sous test 2. Les coefficients $S_{11}$ et $S_{21}$ représentent respectivement le coefficient de réflexion et le coefficient de transmission de la structure sous test 2, lorsque le dispositif est monté en sens direct. Les coefficients $S_{22}$ et $S_{12}$ représentent respectivement le coefficient de réflexion et le coefficient de transmission de la structure sous test 2, lorsque le dispositif estmonté en sens inverse.

Par ailleurs, les moyens d'analyse effectuent le calcul du taux $\eta$ de puissance perdue par le connecteur 2 et le champ $\vec{E}$ rayonné par ce connecteur 2, déduits des paramètres de répartition $S_{11}$, $S_{21}$, $S_{12}$ et $S_{22}$.

Tout d'abord, lors d'une étape de fourniture d'un signal de référence aux moyens d'analyse 6, mise en oeuvre dans le dispositif de calibrage représenté à la figure 6, la première voie de réception 20 des moyens d'analyse 6 reçoit le signal impulsionnel 26 émis par le générateur d'impulsions 4 et capté par la sonde 14. Après avoir été échantillonné par la première voie de réception 20 des moyens d'analyse 6, ce signal impulsionnel est stocké dans la mémoire RAM 36.

Pour le calcul des coefficients de réflexion $S_{11}$ et $S_{22}$, selon que le dispositif est monté en sens direct ou en sens inverse, les moyens d'analyse 6 reçoivent en entrée du soustracteur 34, un signal, tel que celui représenté à la figure 7A.

Ce signal comprend le signal impulsionnel 26 émis par le générateur d'impulsions 4 dont la première partie 28 de forme gaussienne est reçue par les moyens d'analyse 6; avant un instant prédéterminé T0. Ce signal comprend en outre le signal impulsionnel 62 réfléchi par le connecteur 2, reçu par les moyens d'analyse 6 entre l'instant TO et un instant T1 prédéterminé.

Enfin, ce signal comprend des échos parasites 64, reçus par les moyens d'analyse 6 au-delà de l'instant T1.

.En référence à la figure 7B, le signal fourni par le soustracteur 34 au filtre 38, après soustraction du signal impulsionnel 26 stocké dans la mémoire RAM 36, comporte un signal 66 résiduel de la partie gaussienne du signal impulsionnel 26. Ce signal résiduel 66 est reçu par les moyens d'analyse 6 avant l'instant TO. Entre les instants TO et T1, ce signal comporte uniquement le signal impulsionnel réfléchi 62 auquel a été soustraite la seconde partie 30 linéaire du signal impulsionnel 26. Au-delà de l'instant T1, ce signal comporte les échos parasites 64.

Ce signal est ensuite modulé dans le filtre 38 par une fonction temporelie représentée à la figure 7C. Cette fonction modulante est une fonction créneau prenant la valeur 1 entre les instants TO et T1 et nulle partout ailleurs.

Par conséquent, comme représenté à la figure 7D, le signal fourni au circuit 40 par les moyens d'analyse 6, ne comporte plus que le signal réfléchi 62.

Pour le calcul des coefficients de transmission $S_{21}$ et $S_{12}$, les moyens 32 de filtrage temporel reçoivent en entrée du filtre 42, un signal, tel que représenté à la figure 8A. Ce signal comporte le signal impulsionnel 68 transmis par le connecteur 2, présentant une première partie 70 de forme gaussienne reçue par les moyens d'analyse 6 entre des instants prédéterminés T2 et T3, et une seconde partie 72 linéaire s'étendant au-delà de l'instant T3. Ce signal comporte en outre des signaux parasites 74 reçus par les moyens d'analyse 6 au-delà de l'instant T3, mais se superposant à la seconde partie 72 du signal transmis 68.

Dans le filtre 42, le signal représenté à la figure 8A est modulé par une fonction, telle que représentée à la figure 8B.

Cette fonction modulante est une fonction créneau valant 1 entre les instants T2 et T3 et nulle partout ailleurs.

Ainsi, comme représenté à la figure 8C, le signal fourni aux moyens 44 de prolongement par continuité est un signal débarrassé des signaux parasites 74, mais présentant une discontinuité à l'instant T3.

Comme représenté à la figure 8D, les moyens 44 de prolongement par continuité effectuent un prolongement linéaire par continuité du signal représenté à la figure 8C. Eh effet, ce signal tronqué, est complété par une partie linéaire, dont la pente est égale à la pente du signal tronqué au voisinage de l'instant T3.

Ainsi, le signal représenté à la figure 8D, fourni au circuit 40 par les moyens d'analyse 6; ne comporte plus que le signal transmis 68 par le connecteur 2.

Le calcul des coefficients spectraux de l'impulsion 26 émise par le générateur d'impulsions 4, de l'impulsion réfléchie par le connecteur 2 et de l'impulsion transmise par ce même connecteur 2, est alors effectué par le circuit 40 de calcul de spectre. Ce calcul est considéré comme classique et ne sera donc pas détaillé.

Le calcul des paramètres $S_{11}$, $S_{21}$, $S_{12}$ et $S_{22}$ par les moyens de calcul 41 a du calculateur 41 nécessite la mise en oeuvre d'un procédé de calibrage préalable, afin de compenser des erreurs systématiques, dépendantes de la structure du dispositif de caractérisation électromagnétique, tel que représenté à la figure 1 ou à la figure 4.

Ce procédé de calibrage, ainsi que le calcul des paramètres de répartition par les moyens de calcul 41 a, sont également considérés comme classiques et ne seront pas décrits.

Par exemple, pour le dispositif représenté à la figure 1, le procédé de calibrage généralement utilisé est un procédé de calibrage classique de type SOLT (Short Open Load Thru).

Le procédé de calibrage mis en oeuvre pour le dispositif représenté à la figure 4 est un procédé de calibrage de type TRL (Thru, Reflect, Line). Un tel procédé de ce calibrage, ainsi qu'un procédé de calcul des paramètres de répartition pour le dispositif représenté à la figure 4, est décrit dans l'article intitulé "Improving TRL calibrations of vector network analysers", de Don Metzger, publié dans Microwave Journal, Mai 1995, pages 56 à 68.

Ensuite, les moyens de calcul 41 b effectuent le calcul du taux η de puissance rayonnée par le connecteur 2. Ce taux est donné par la formule suivante (en sens direct) :

$$\eta = 1 - |S_{11}|^2 - |S_{21}|^2.$$

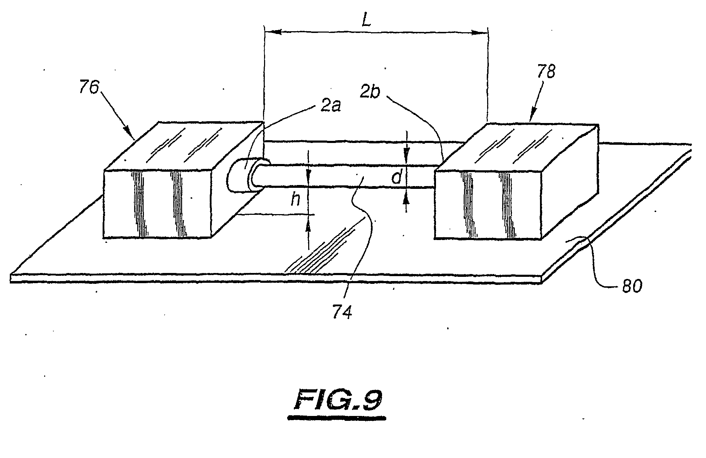

Enfin, les moyens de calcul 41 c effectuent le calcul du champ $\vec{E}$ rayonné par le connecteur 2, lorsque celui-ci est utilisé dans la mise en oeuvre d'une liaison entre un émetteur et un récepteur, telle que représentée à la figure 9.

Le montage représenté sur cette figure comporte une ligne de transmission 74 d'impédance quelconque, de longueur L et de diamètre d; connectée d'une part à un émetteur 76 au moyen d'un connecteur 2a, tel que le connecteur 2, et est connectée à un récepteur 78 au moyen d'un autre connecteur 2b tel que le connecteur 2.

Cette ligne de transmission 74 est en outre disposée à une hauteur h, par rapport à un plan de masse 80 du montage.

Les connecteurs 2a et 2b peuvent être assimilés à des générateurs de courants de mode commun $I_{c1}$ et $I_{c2}$.

Le courant de mode commun $I_{c1}$ du connecteur 2a proche de l'émetteur 76, est donné par la formule suivante :

$$I_{c1} = \sqrt{\frac{2\eta}{Z_c}},$$

où

$$Z_c = 60 \ln \left( \frac{4h}{d} \right)$$

est l'impédance caractéristique de la ligne de transmission 74.

Le courant de mode commun $I_{c2}$ du connecteur 2b proche du récepteur 78, est donné par la formule suivante :

$$I_{c2} = \left(1 - \sqrt{\eta}\right) I_{c1} \, e^{-j\beta L}$$

où $\beta = \frac{2\pi f}{\lambda}$, avec f et $\lambda$ étant la fréquence et la longueur d'onde d'un courant traversant la ligne de transmission 74.

Le champ lointain $\vec{E}_1$ rayonné par le montage et dû à la présence du connecteur 2a, est alors estimé en coordonnées polaires, en prenant le montage pour origine, par la relation suivante :

$$\overrightarrow{E_1 (r,\theta)} = j\frac{k}{4\pi} \, Z_0 \psi(r) \, \sin\theta \, \frac{\sin X_1}{X_1} \, I_{c1} \, L.2\sin Y \, \vec{U}_\theta$$

avec

$$X_1 = \frac{kL}{2} (\cos\theta - 1)$$

et

$$Y = \frac{2\pi h}{\lambda} \sin\theta$$

où

$$Z_0 = 120\pi \, , \psi(r) = \frac{e^{-jkr}}{r}, \, k = \frac{2\pi f}{c}$$

Le champ lointain $\vec{E}_2$ rayonné par le montage et dû à la présence du connecteur 2b est estimé par la relation suivante

$$\overrightarrow{E_2(r,\theta)} = j\frac{k}{4\pi} \, Z_0 \psi(r) \sin\theta \, \frac{\sin X_2}{X_2} \, I_{c2} L.2\sin Y \, (\overline{-U}_\theta)$$

avec

$$X_2 = \frac{kL}{2} (\cos\theta + 1)$$

et

$$Y = \frac{2\pi h}{\lambda} \sin\theta$$

où

$$Z_0 = 120\pi, \; \psi(r) = \frac{e^{-jkr}}{r}, \; k = \frac{2\pi f}{c}$$

Ainsi, le champ rayonné total devient :

$$\overrightarrow{E(r,\theta)} = j\frac{k}{4\pi} Z_0 \, \psi(r) \, \sin\theta \frac{\sin X_1}{X_1} I_{c1} \, L.2\sin Y \, U_\theta$$

$$+ j\frac{k}{4\pi} Z_0 \, \psi(r) \, \sin\theta \frac{\sin X_2}{X_2} \left(1 - \sqrt{\eta}\right) I_{c1} \, e^{-j\beta L} L.2\sin Y(-\overrightarrow{U_\theta})$$

On en déduit la valeur du module du champ total rayonné par le montage en présence des connecteurs 2a et 2b, donnée par la relation suivante :

$$\left| rE(r,\theta) \right| = \left| \frac{60\pi}{c} f L I_{c1} \sin\theta \, 2\sin Y \right|$$

$$\times \sqrt{\left(\left(\frac{\sin X_1}{X_1} - \frac{\sin X_2}{X_2}\right)\left(1 - \sqrt{\eta}\right)\cos\beta L\right)^2 + \left(\left(\frac{\sin X_2}{X_2}\right)\left(1 - \sqrt{\eta}\right)\sin\beta L\right)^2}$$

Il apparaît clairement qu'un dispositif de caractérisation électromagnétique selon l'invention permet de caractériser la structure 2 sous test sur toute la bande de fréquences prédéterminée, à l'aide de l'impulsion 26 émise par le générateur d'impulsions 4.

En effet, les moyens d'analyse 6 possèdent des moyens 32 de filtrage temporel permettant la discrimination de l'impulsion émise par le générateur d'impulsions 4, de l'impulsion réfléchie par le connecteur 2, de l'impulsion transmise par ce même connecteur 2, et le rejet des signaux parasites.

De plus, ils comportent des moyens de calcul des paramètres de dispersion du connecteur 2, du taux de puissance rayonnée par le connecteur 2 et du champ rayonné par ce connecteur 2.

## Revendications

**1.** Dispositif de caractérisation électromagnétique d'une structure (2) sous test terminée par des connecteurs reliés à des lignes de transmission d'impédance quelconque, par l'évaluation, sur une bande de fréquences prédéterminée, de paramètres de répartition de cette structure (2) et de paramètres caractéristiques des rayonnements parasites de cette structure (2), comportant un générateur (4) de signal électrique, des moyens (8) de transmission de ce signal électrique à la structure (2) sous test, des moyens (6) d'analyse du signal émis par le générateur (4), ainsi que des signaux réfléchis par la structure (2) et des signaux transmis par la structure (2), les moyens d'analyse (6) comportant des moyens (41) de calcul des paramètres de répartition et des paramètres caractéristiques des rayonnements parasites de la structure sous test, **caractérisé en ce que** le générateur (4) de signal électrique est un générateur d'un signal impulsionnel (26) dont le spectre est au moins aussi large que ladite bande de fréquences prédéterminée, le générateur étant adapté pour émettre au moins une fois ce signal impulsionnel (26), et **en ce que** les moyens d'analyse (6) comportent des moyens (32) de filtrage temporel des signaux qu'ils reçoivent, pour l'élimination de signaux parasites (64,74).

2. Dispositif de caractérisation électromagnétique selon la revendication 1, **caractérisé en ce que**, la structure (2) sous test étant terminée par des connecteurs multifilaires, le dispositif comporte en outre des moyens (46,48) d'adaptation d'impédance et de mode de propagation disposés entre ces connecteurs multifilaires et le reste du dispositif.

3. Dispositif de caractérisation électromagnétique selon la revendication 2, **caractérisé en ce que**, la structure (2) sous test étant terminée par des connecteurs reliés chacun à au moins une ligne bifilaire (50,52), les moyens (46,48) d'adaptation comportent une pluralité d'adaptateurs de chaque ligne bifilaire disposés de part et d'autre de la structure (2) sous test, chacun comprenant un circuit (57) de fractionnement de tension et une borne (58,60) de connexion bifilaire formée par les deux conducteurs centraux de deux câbles coaxiaux (60) dont les conducteurs extérieurs sont court-circuités.

4. Dispositif de caractérisation électromagnétique selon l'une quelconque des revendications 1 à 3, **caractérisé en ce qu'**il comporte en outre des moyens de transmission (8,14,12,18) du signal impulsionnel (26) seul, aux moyens d'analyse (6), pour la fourniture d'un signal de référence de ceux-ci.

5. Dispositif de caractérisation électromagnétique selon l'une quelconque des revendications 1 à 4, **caractérisé en ce que** la largeur de la bande de fréquences prédéterminée est supérieure ou égale à 1 GHz.

6. Dispositif de caractérisation électromagnétique selon l'une quelconque des revendications 1 à 5, **caractérisé en ce que** le signal impulsionnel (26) est le signal impulsionnel de forme générale gaussienne.

7. Dispositif de caractérisation électromagnétique selon l'une quelconque des revendications 1 à 6, **caractérisé en ce que** les moyens d'analyse (6) comportent une première voie (20,34,48) de traitement du signal émis par le générateur (4) et du signal réfléchi par la structure (2) sous test, comprenant au moins une voie de réception (20), et une seconde voie (24,42,44) de traitement du signal transmis par la structure (2) sous test comprenant au moins une voie de réception (24).

8. Dispositif de caractérisation électromagnétique selon la revendication 7, **caractérisé en ce que** les moyens (32) de filtrage temporel comportent des premiers moyens (38) de sélection entre des instants prédéterminés d'une partie des signaux reçus par la première voie de traitement (20,34,38), cette partie contenant uniquement le signal réfléchi par la structure (2) sous test, et des seconds moyens (42) de sélection entre des instants prédéterminés d'une partie des signaux reçus par la seconde voie de traitement (24,42,44), cette partie contenant uniquement le signal transmis par la structure (2) sous test.

9. Dispositif de caractérisation électromagnétique selon la revendication 8, **caractérisé en ce que** des moyens (44) de prolongement par continuité de ladite partie contenant uniquement le signal transmis par la structure (2) sous test, pour la reconstitution de. ce signal transmis, sont associés auxdits seconds moyens de sélection (42).

10. Dispositif de caractérisation électromagnétique selon l'une quelconque des revendications 1 à 9, **caractérisé en ce que** la structure (2) sous test est un connecteur de liaisons multifilaires.

11. Dispositif de caractérisation électromagnétique selon l'une quelconque des revendications 1 à 10, **caractérisé en ce que** les moyens de calcul (41) comportent des moyens (41 b) de calcul du taux de puissance rayonnée par la structure (2) sous test.

12. Dispositif de caractérisation électromagnétique selon la revendication 11, **caractérisé en ce que** la structure (2) sous test étant un connecteur de liaisons multifilaires, les moyens de calcul (41) comportent des moyens (41c) de calcul du champ rayonné par ce connecteur (2), lorsque celui-ci est utilisé dans la mise en oeuvre d'une liaison entre un émetteur (76) et un récepteur (78) de signaux électriques.

13. Procédé de caractérisation électromagnétique d'une structure (2) sous test terminée par des connecteurs reliés à des lignes de transmission d'impédance quelconque, par l'évaluation, sur une bande de fréquences prédéterminée, de paramètres de répartition de cette structure (2) et de paramètres caractéristiques des rayonnements parasites de cette structure (2), le procédé comportànt les étapes suivantes :

- l'émission, au moins une fois, par un générateur (4) d'un signal électrique vers la structure (2) sous test ;
- la réception du signal émis par le générateur (4) ainsi que des signaux réfléchis par la structure (2) et des signaux transmis par la structure (2), par des moyens d'analyse (6) ; et
- le calcul par les moyens d'analyse (6) des paramètres de répartition de la structure (2) sous test et des paramètres caractéristiques des rayonnements parasites de cette structure (2),

    **caractérisé en ce que** le signal électrique est un signal impulsionnel (26) de largeur spectrale supérieure à ladite bande de fréquences prédéterminée, et **en ce que** le procédé comporte en outre une étape de filtrage temporel des signaux reçus par les moyens d'analyse (6), pour l'élimination de signaux parasites (64,74).

**Patentansprüche**

1. Einrichtung zur elektromagnetischen Charakterisierung einer zu testenden Struktur (2), welche in Verbindern endet, die mit Übertragungsleitungen beliebiger Impedanz verbunden sind, durch Auswertung in einem vorausbestimmten Frequenzband von Verteilungsparametern dieser Struktur (2) und von Parametern, die für Störstrahlungen dieser Struktur (2) charakteristisch sind, enthaltend einen Generator (4) zur Erzeugung eines elektrischen Signals, Mittel (8) zur Übertragung dieses elektrischen Signals an die zu testende Struktur (2), Mittel (6) zur Analyse des vom Generator (4) emittierten Signals wie auch der von der Struktur (2) reflektiert Signale und der von der Struktur (2) übertragenen Signale, wobei die Mittel zur Analyse (6) Mittel (41) zur Berechnung der Verteilungsparameter und der charakteristischen Parameter der Störstrahlungen der zu testenden Struktur enthalten, **dadurch gekennzeichnet, dass** der Generator (4) zur Erzeugung des elektrischen Signals ein Generator zur Erzeugung eines impulsartigen Signals (26) ist, dessen Spektrum mindestens ebenso breit ist wie das genannte vorausbestimmte Frequenzband, wobei der Generator dazu ausgebildet ist, wenigstens ein Mal dieses impulsartige Signal (26) zu emittieren, und dass die Mittel zur Analyse (6) zur Eliminierung von Störsignalen (64, 74) Mittel (32) zur zeitlichen Filterung der Signale enthalten, die sie empfangen,

2. Einrichtung zur elektromagnetischen Charakterisierung nach Anspruch 1, **dadurch gekennzeichnet, dass**, wenn die zu testende Struktur (2) in mehradrigen Verbindern endet, die Einrichtung außerdem Mittel (46, 48) zur Anpassung der Impedanz und der Ausbreitungsmoden enthält, welche zwischen diesen mehradrigen Verbindern und dem Rest der Einrichtung angeordnet sind.

3. Einrichtung zur elektromagnetischen Charakterisierung nach Anspruch 2, **dadurch gekennzeichnet dass**, wenn die zu testende Struktur (2) in Verbindern endet, von denen jeder mindestens mit einer zweiadrigen Leitung (50, 52) verbunden ist, die Mittel (46, 48) zur Anpassung eine Mehrzahl von Anpassungsgliedem für jede zweiadrige Leitung enthalten, die beiderseits der zu testenden Struktur (2) angeordnet sind, von denen jeder eine Spannungsteilerschaltung (57) und eine zweiadrige Verbindungsklemme (58, 60) enthält, welche durch die beiden Innenleiter zweier Koaxialkabel (60) gebildet wird, deren Außenleiter kurzgeschlossen sind.

4. Einrichtung zur elektromagnetischen Charakterisierung nach einem der Ansprüche 1 bis 3, **dadurch gekennzeichnet, dass** sie außerdem Mittel zur Übertragung (8, 14, 12, 18) allein des impulsartigen Signals (26) an die Mittel zur Analyse (6) enthält, zur Lieferung eines Referenzsignals von diesen.

5. Einrichtung zur elektromagnetischen Charakterisierung nach einem der Ansprüche 1 bis 4, **dadurch gekennzeichnet, dass** die Breite des vorausbestimmten Frequenzbandes größer oder gleich 1 GHz ist.

6. Einrichtung zur elektromagnetischen Charakterisierung nach einem der Ansprüche 1 bis 5, **dadurch gekennzeichnet, dass** das impulsartige Signal (26) ein impulsartiges Signal einer allgemeinen gaußschen Form ist.

7. Einrichtung zur elektromagnetischen Charakterisierung nach einem der Ansprüche 1 bis 6, **dadurch gekennzeichnet, dass** die Mittel zur Analyse (6) einen ersten Pfad (20, 34, 48) enthalten zur Verarbeitung des vom Generator (4) emittierten Signals und des von der zu testenden Struktur (2) reflektierten Signals, enthaltend zumindest einen Empfangspfad (20), und einen zweiten Pfad (24, 42, 44) zur Verarbeitung des von der zu testenden Struktur (2) übertragenen Signals, enthaltend wenigstens einen Empfangspfad (24).

8. Einrichtung zur elektromagnetischen Charakterisierung nach Anspruch 7, **dadurch gekennzeichnet, dass** die Mittel (32) zur zeitlichen Filterung erste Mittel (38) enthalten zur Auswahl eines Teils der über den ersten Signalverarbeitungspfad (20, 34, 38) empfangenen Signale zwischen vorausbestimmten Zeitpunkten, wobei dieser Teil

**EP 1 342 094 B1**

lediglich das von der zu testenden Struktur (2) reflektierte Signal enthält, und zweite Mittel (42) zur Auswahl eines Teils der über den zweiten Signalverarbeitungspfad (24, 42, 22) empfangenen Signale zwischen vorausbestimmten Zeitpunkten, wobei dieser Teil lediglich das von der zu testenden Struktur (2) übertragene Signal enthält.

**9.** Einrichtung zur elektromagnetischen Charakterisierung nach Anspruch 8, **dadurch gekennzeichnet, dass** Mittel (44) zur kontinuierlichen Verzögerung des genannten Teils, welcher lediglich das von der zu testenden Struktur (2) übertragene Signal enthält, zur Wiederherstellung dieses übertragenen Signals mit den genannten zweiten Mitteln zur Auswahl (42) verbunden sind.

**10.** Einrichtung zur elektromagnetischen Charakterisierung nach einem der Ansprüche 1 bis 9, **dadurch gekennzeichnet, dass** die zu testende Struktur (2) ein Verbinder mit mehradrigen Verbindungen ist.

**11.** Einrichtung zur elektromagnetischen Charakterisierung nach einem der Ansprüche 1 bis 10, **dadurch gekennzeichnet, dass** die Mittel zur Berechnung (41) Mittel (41b) zur Berechnung der von der zu testenden Struktur (2) abgestrahlten Verlustleistung enthalten.

**12.** Einrichtung zur elektromagnetischen Charakterisierung nach Anspruch 11, **dadurch gekennzeichnet, dass**, wenn die zu testende Struktur (2) ein Verbinder mit mehradrigen Verbindungen ist, die Mittel zur Berechnung (41) Mittel (41c) zur Berechnung des von diesem Verbinder (2) abgestrahlten Feldes enthalten, wenn dieser bei der Herstellung einer Verbindung zwischen einem Sender (76) und einem Empfänger (78) elektrischer Signale verwendet wird.

**13.** Verfahren zur elektromagnetischen Charakterisierung einer zu testenden Struktur (2), welche in Verbindern endet, die mit Übertragungsleitungen beliebiger Impedanz verbunden sind, durch Auswertung in einem vorausbestimmten Frequenzband von Verteilungsparametern dieser Struktur (2) und von Parametern, die für Störstrahlungen dieser Struktur (2) charakteristisch sind, wobei das Verfahren folgende Schritte enthält:

- die mindestens einmalige Emission eines elektrischen Signals durch einen Generator (4) in Richtung auf die zu testende Struktur (2);
- der Empfang des vom Generator (4) emittierten Signals sowie von Signalen, die von der Struktur (2) reflektiert wurden und von Signalen, die von der Struktur (2) übertragen wurden, durch Mittel zur Analyse (6); und
- die Berechnung von Verteilungsparametern der zu testenden Struktur und von Parametern, die für Störstrahlungen dieser Struktur (2) charakteristisch sind, durch die Mittel zur Analyse (6);

   **dadurch gekennzeichnet, dass** das elektrische Signal ein impulsartiges Signal (26) ist mit einer spektralen Bandbreite größer als das genannte vorausbestimmte Frequenzband, und dass das Verfahren außerdem zur Eliminierung von Störsignalen (64, 74) einen Schritt zur zeitlichen Filterung der von den Mitteln zur Analyse (6) empfangenen Signale enthält.

**Claims**

**1.** A device for electromagnetically characterising a structure (2) under test terminated by connectors connected to transmission lines of any impedance by evaluating over a predetermined band of frequencies distribution parameters of said structure (2) and parameters characteristic of unwanted radiation from said structure (2), said device comprising an electrical signal generator (4), means (8) for transmitting said electrical signal to the structure (2) under test, and means (6) for analysing the signal sent by the generator (4), signals reflected by the structure (2), and signals transmitted by the structure (2), the analysis means (6) comprising means (41) for calculating distribution parameters and parameters characteristic of unwanted radiation from the structure under test, which device is **characterised in that** the electrical signal generator (4) generates a pulse signal (26) whose spectrum is at least as wide as said predetermined band of frequencies and is adapted to emit said pulse signal (26) at least once and **in that** the analysis means (6) comprise means (32) for temporally filtering signals that they receive to eliminate unwanted signals (64, 74).

**2.** An electromagnetic characterisation device according to claim 1, **characterised in that**, the structure (2) under test being terminated by multiway connectors, the device further comprises means (46, 48) for adapting the impedance and the mode of propagation between said multiway connectors and the remainder of the device.

3. An electromagnetic characterisation device according to claim 2, **characterised in that**, the structure (2) under test being terminated by connectors each connected to at least one two-wire line (50, 52), the adaptation means (46, 48) comprise a plurality of adaptors of each two-wire line on either side of the structure (2) under test and each comprising a voltage divider circuit (57) and a two-wire connection terminal (58, 60) formed by the two centre conductors of two coaxial cables (60) whose outer conductors are shortcircuited.

4. An electromagnetic characterisation device according to any of claims 1 to 3, **characterised in that** it further comprises means (8, 14, 12, 18) for transmitting the pulse signal (26) to the analysis means (6) on its own in order to provide a reference signal.

5. An electromagnetic characterisation device according to any of claims 1 to 4, **characterised in that** the width of the predetermined band of frequencies is greater than or equal to 1 GHz.

6. An electromagnetic characterisation device according to any of claims 1 to 5, **characterised in that** the general shape of the pulse signal (26) is a Gaussian shape.

7. An electromagnetic characterisation device according to any of claims 1 to 6, **characterised in that** the analysis means (6) comprise a first channel (20, 34, 48) for processing the signal emitted by the generator (4) and the signal reflected by the structure (2) under test and comprising at least one receive channel (20), and a second channel (24, 42, 44) for processing the signal transmitted by the structure (2) under test and comprising at least one receive channel (24).

8. An electromagnetic characterisation device according to claim 7, **characterised in that** the temporal filtering means (32) comprise first means (38) for selecting, between predetermined times, a portion of the signals received by the first processing channel (20, 34, 38), said portion containing only the signal reflected by the structure (2) under test, and second means (42) for selecting, between predetermined times, a portion of the signals received by the second processing channel (24, 42, 44), this portion containing only the signal transmitted by the structure (2) under test.

9. An electromagnetic characterisation device according to claim 8, **characterised in that**, for the purposes of reconstituting said transmitted signal, said second selector means (42) are associated with means (44) for continuously extending said portion containing only the signal transmitted by the structure (2) under test.

10. An electromagnetic characterisation device according to any of claims 1 to 9, **characterised in that** the structure (2) under test is a multiway connector.

11. An electromagnetic characterisation device according to any of claims 1 to 10, **characterised in that** the calculation means (41) comprise means (41b) for calculating the power radiated by the structure (2) under test.

12. An electromagnetic characterisation device according to claim 11, **characterised in that**, the structure (2) under test being a multiway connector, the calculation means (41) comprise means (41c) for calculating the field radiated by said connector (2) when it is used in a connection between a sender (76) of electrical signals and a receiver (78) of electrical signals.

13. A method of electromagnetically characterising a structure (2) under test terminated by connectors connected to transmission lines of any impedance by evaluating over a predetermined band of frequencies distribution parameters of said structure (2) and parameters characteristic of unwanted radiation from said structure (2), the method comprising the following steps:

- a generator (4) sending an electrical signal to the structure (2) under test at least once;
- analysis means (6) receiving the signal sent by the generator (4), signals reflected by the structure (2), and signals transmitted by the structure (2), and
- the analysis means (6) calculating distribution parameters of the structure (2) under test and parameters characteristic of unwanted radiation from said structure (2),

which method is **characterised in that** the electrical signal is a pulse signal (26) whose spectrum is wider than said predetermined band of frequencies and **in that** the method further comprises a step of temporally filtering signals received by the analysis means (6) to eliminate unwanted signals (64, 74).

*FIG.1*

*FIG.2*

_FIG.3_

_FIG.4_

_FIG.5_

_FIG.6_

_FIG.7A_

_FIG.7B_

_FIG.7C_

_FIG.7D_

_FIG.8A_

_FIG.8B_

_FIG.8C_

_FIG.8D_

_FIG.9_